## Europäisches Patentamt

## European Patent Office

## Office européen des brevets

(11) Veröffentlichungsnummer: **0 172 132**
**B1**

## (12) EUROPÄISCHE PATENTSCHRIFT

(45) Veröffentlichungstag der Patentschrift:
**15.11.89**

(21) Anmeldenummer: **85730110.5**

(22) Anmeldetag: **16.08.85**

(51) Int. Cl.⁴: **G 01 R 31/28**

(54) **Prüfadapter.**

(30) Priorität: **16.08.84  DE 8424493 U**

(43) Veröffentlichungstag der Anmeldung:
**19.02.86 Patentblatt 86/8**

(45) Bekanntmachung des Hinweises auf die Patenterteilung:
**15.11.89 Patentblatt 89/46**

(84) Benannte Vertragsstaaten:
**AT BE CH DE FR GB IT LI NL**

(56) Entgegenhaltungen:
**DE-A-2 437 651**

(73) Patentinhaber: **BRUMM GmbH Elektronik-
Gerätebau, Kreuzbergstrasse 30, D-1000 Berlin 61
(DE)**

(72) Erfinder: **Brumm, Gerhard, Totilastrasse 33a, D-1000
Berlin 42 (DE)**

(74) Vertreter: **Christiansen, Henning, Dipl.- Ing.,
Patentanwalt CHRISTIANSEN Pacelliallee 43/45,
D-1000 Berlin 33 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1989

## Beschreibung

Die Erfindung betrifft einen Prüfadapter der im Oberbegriff des Anspruchs 1 angegebenen Art.

Derartige Prüfadapter werden im Zusammenhang mit elektronischen Geräten benutzt, welche eine Anzahl von Schaltungsplatinen in Reihen dicht nebeneinander angeordnet enthalten. Bei derartigen Geräten können bei Störungen die einzelnen Platinen (Leiterplatten) nicht direkt innerhalb des Gerätes überprüft werden, da die räumlichen Platzverhältnisse keinen Zugang zur Leiter- oder Bauelementeseite zwecks Überprüfung oder zum Austausch von Bauelementen zulassen. Die dichte Anordnung der Platinen ist aber andererseits notwendig, um die Baugröße von elektronischen Geräten, welche eine Vielzahl von Baugruppen enthalten, nicht unnötig zu vergrößern. Ein derartiger Prüfadapter ist beispielsweise aus der DE-A-2 437 651 bekannt.

Die eingangs genannten Prüfadapter dienen nun dazu, beispielsweise im Service- oder Reparaturfall eine einzelne Schaltungsplatine außerhalb des Bereiches, in dem diese Platine sich im Betriebszustand befindet, frei zugänglich zu halten. Der Prüfadapter bildet dabei eine Art Leiterplattenverlängerung, wobei zusätzlich die Möglichkeit besteht, mittels Prüfbuchsen oder auf andere Weise die einzelnen Leiterbahnen, welche die Verbindung zwischen den Anschlüssen der Schaltungsplatine und den innerhalb des Gerätes verlaufenden Sammelleitungen bilden, einzeln zu Meß- und Prüfzwecken zu kontaktieren. Damit brauchen die einzelnen Leitungsverbindungen, welche den Energie- und Signalaustausch zwischen dem Grundgerät und der auf der Platine befindlichen Baugruppen bewirken, nicht auf der Platine selbst aufgesucht werden, sondern es kann auf einfache Weise eine Verbindung zu Meßzwecken mittels entsprechender Prüfklemmen oder -stecker über den Prüfadapter erzeugt werden.

Der aus der DE-A-2 437 651 bekannte Prüfadapter weist mehrere Nachteile auf. Zum einen ist das Anzeigeelement in Reihe mit dem Prüfling geschaltet, d. h. eine Anzeige erfolgt nur bei geschlossenem Stromkreis. Zum anderen kann kein Potential gemessen werden. Ferner kann ein Spannungsabfall an der Anzeige die Funktion des Prüflings beeinträchtigen und die Effektivität der Anzeige wiederum ist vom Gesamtwiderstand abhängig. Auch ist die Anzeige nur von einer Seite lesbar. Treten Störungen an irgend einem Bauelement des Zwischenadapters (Lampe, Steckverbinder usw.) auf, führt dies zwangsläufig auch zu Fehlfunktionen des Prüflings und damit zu einer Fehldiagnose. Der Zwischenadapter in DE-A-2 437 651 verlängert den Gesamtadapter unnötigerweise, wodurch die Stabilität eingeschränkt wird. Die bekannten Prüfadapter haben allgemein auch den Nachteil, daß die Meßwerte, welche Signale auf den einzelnen Verbindungsleitungen betreffen, jeweils ausschließlich mittels externer Meßgeräte - und zwar sowohl <u>einzeln</u> als auch <u>nacheinander</u> - verarbeitet und angezeigt werden können.

Der im Anspruch 1 angegebenen Erfindung liegt demgegenüber die Aufgabe zugrunde, einen Prüfadapter zu schaffen, welcher direkt eine Anzeige für analoge, Status- oder sonstige Signale bietet.

Der Erfindung liegt die Erkenntnis zugrunde, daß bei der Überprüfung von elektronischen Schaltungsplatinen möglichst alle anstehenden Signale während der Überprüfungs- oder Reparaturarbeiten beständig angezeigt und somit zur Auswertung zugänglich sein sollten. Derartige Signale sind bei logischen Schaltbaugruppen insbesondere die Statusinformationen auf den Datenleitungen ("High" oder "Low") bzw. beispielsweise die Anzeige der auf den Versorgungsleitungen vorhandenen Spannungen. Für die Verarbeitung und Aufbereitung derartiger Signale zwecks Darbietung auf einem optischen Display sind aber ebenfalls elektronische Baugruppen notwendig, welche auf dem Prüfadapter untergebracht werden müssen.

Die Erfindung geht des weiteren davon aus, daß ein derartiger Raum auf dem Prüfadapter entweder in dem Bereich zur Verfügung steht, welcher bei der entsprechenden anstelle des Prüfadapters direkt in das Gerät eingesteckten elektronischen Schaltungsplatine für deren elektronische Bauelemente vorgesehen ist - also auf der Bauelementeseite benachbart zu derjenigen Kontaktleiste, welche zum Verbinden mit dem Gerät vorgesehen ist, in dem die zu überprüfende elektronische Schaltungsplatine sonst ihren Platz findet, oder aber auf der Lötseite, hier jedoch außerhalb des Gerätes, dem die Schaltungsplatine zu Prüfzwecken entnommen wurde.

Bei einer alternativen Ausführung ist deshalb das Gehäuse zur Aufnahme der elektronischen Bauelemente (gegebenenfalls zusätzlich) auf der Lötseite des Prüfadapters in demjenigen Bereich vorgesehen, der gegenüber den Kontaktbuchsen oder Kontaktelementen zur Herstellung von elektrischen Verbindungen zwischen zusätzlichen Meßmitteln und den Leiterbahnen auf dem Prüfadapter vorgesehen ist. Dieser Bereich liegt bei in das Gerät eingestecktem Prüfadapter außerhalb derjenigen Zone, welche sich im Prüfzustand zwischen dem benachbarten Schaltungsplatinen befindet. Er überragt die genormte Länge der Platinen und ist somit während der auszuführenden Arbeiten nicht von benachbarten Platinen behindert, so daß auf seiner einen Seite freier Zugriff zur Kontaktierung der Leiterbahnen besteht, während auf der gegenüberliegenden Seite das Gehäuse zur Aufnahme der elektronischen Bauelemente einschließlich Display nicht in seiner Bauhöhe begrenzt ist.

Auf diese Weise lassen sich die elektronischen Baugruppen einschließlich Display auf einem Prüfadapter bekannter Art anordnen, ohne daß dieser bezüglich der Abmessungen der die Steck- und Leitungsverbindungen tragenden Platine vergrößert werden müßte. Ein Anzeigedisplay ist - in vertikaler Ausrichtung zur Platine des Prüfadapters und in Richtung zur Kontaktleiste zur Aufnahme der zu messenden Schaltungsplatine orientiert - in das Gehäuse für die elektronischen Signalverarbeitungsbaugruppen integriert vorgesehen. Die größte Erstreckung des Displays ist dabei parallel zur Platine ausgerichtet.

Die Displayanordnung besteht bevorzugt aus einer Leuchtdiodenmatrix, welche in ihrer Diodenanordnung den Kontakten der Kontaktleisten entspricht, so daß in sinnfälliger Weise der Signalzustand jeder Leitung direkt erkennbar ist. Ein intermittierendes Datensignal auf dem betreffenden Leitungen zeichnet sich dabei z. B. durch ein Flackern der Dioden bzw. Aufleuchten mit einer Helligkeit, wie sie der mittleren Signalamplitude entspricht, aus.

Bei Anordnung des Gehäuses für die elektronischen Signalverarbeitungsbaugruppen auf der den Prüfbuchsen gegenüberliegenden Seite entspricht die Höhe des Anzeigefeldes bevorzugt derjenigen der Kontaktleiste des Prüfadapters, die zur Aufnahme des Prüflings dient, während bei Anordnung auf der Bauelementeseite die Displayanordnung benachbart zu dem Prüfbuchsenfeld am Ende desjenigen Bereiches vorgesehen ist, welcher bei einer entsprechenden normalen elektronischen Schaltungsplatine zur Aufnahme der Bauelemente bestimmt ist. Bei eingesteckter Prüfplatine befindet sich die Anzeige kurz oberhalb der benachbarten Platinen und ist somit ebenfalls in ihrer Bauhöhe nicht begrenzt. Die Anzeige ist während der Prüfvorgänge über die zusätzlichen Prüfbuchsen mittels zusätzlicher Meßeinrichtungen auf derselben Seiten sichtbar, so daß sich ein besonders ergonomisches Konzept ergibt.

Bei anderen vorteilhaften Weiterbildungen der Erfindung ist das Gehäuse für die Aufnahme der zusätzlichen Signalverarbeitungsbaugruppen zusammen mit dem Display mittels einer Steckvorrichtung lösbar befestigt und durch mindestens eine zusätzliche Schraube gesichert. Die Steckverbindung ist auf der Bauelementeseite (bzw. gegenüber) auf der Prüfadapterplatin vorgesehen, wobei die Displayanordnung jederzeit nachrüstbar ist oder durch eine solche mit anderer Funktion ausgewechselt werden kann. Derartige andere Funktionen können Frequenzanzeigen, digitale Spannungs- oder Strommeßgeräte oder aber auch ein Logikdisplay sein, welches Aufschluß über wechselnde Signalzustände im Rhythmus des Taktsignals gibt. Die Zahl der Anwendungen nimmt künftig mit der Erhöhung der Komplexität der elektronischen Baugruppen noch zu und kann durch entsprechende Spezialisierungen der Displayeinheit auch genau auf bestimmte elektronische Baugruppen, die zu überprüfen sind, ausgerichtet werden, so daß beispielsweise ein Selbsttestprogramm für die betreffenden Platinen mit Anzeige des Testergebnisses vorgesehen sein kann.

Insbesondere ist es dabei günstig, wenn innerhalb der Display-Anordnung eine zusätzliche digitale oder analoge Anzeigeeinrichtung mit zugehörigem Signalverarbeitungsteil für mindestens eine elektrische Eigenschaft eines auf einer der Leiterbahnen vorhandenen Signals vorgesehen ist, wobei bevorzugt eine Schaltvorrichtung vorgesehen ist, welche die Anzeigeeinrichtung jeweils einer der Leiterbahnen alternativ zuordnet. Die Schaltvorrichtung ist insbesondere mittels einer Auswahlvorrichtung aktivierbar, welche gleichzeitig dasjenige Anzeigeelement der Display-Anordnung adressiert, das derjenigen Leiterbahn zugeordnet ist, für die eine elektrische Eigenschaft eines darauf vorhandenen Signals angezeigt wird, wobei die Auswahlvorrichtung insbesondere ein Schaltelement enthält, durch dessen impulsweise oder zeitabschnittweise Betätigung jeweils ein Zähler weitergesetzt wird) der sowohl die Auswahleinrichtung als auch die Anzeigeeingeeinrichtung nacheinander den einzelnen Leiterbahnen zuordnet. Die Adressierung kann dabei auch mittels anderer Funktionsweisen des Schaltelements erfolgen, wobei bevorzugt nacheinander die Spalten und Zeilen des Displays (einschließlich der zugeordneten Leiterbahnen) adressiert werden. Die Steuerungsfunktionen sind dabei bevorzugt entsprechend der Auswahl von Zeitanzeige und Funktionen bei Digitalarmbanduhren etc. ausgebildet.

Vorteilhafte Weiterbildungen der Erfindung sind in den Unteransprüchen gekennzeichnet bzw. werden nachstehend anhand einer bevorzugten Ausführung näher beschrieben. Es zeigen:

Figuren 1a bis 1c ein erstes Ausführungsbeispiel der Erfindung in Seitenansicht, Draufsicht und Frontalansicht,
Figuren 2a bis 2c ein weiteres Ausführungsbeispiel der Erfindung in entsprechenden Ansichten sowie
Figur 3 ein Blockschaltbild eines Details einer Variante der zuvor dargestellten Ausführungsbeispiele.

(Bei der nachfolgenden Beschreibung der beiden bevorzugten Ausführungsbeispiele der Erfindung sind entsprechende Bauelemente mit jeweils identischen Bezugszeichen versehen. Abwandlungen sind durch ein hinzugefügtes"" gekennzeichnet.) Eine Platine 1 trägt an ihren Stirnseiten jeweils eine Kontaktleiste 2 und 3, welche aufeinander abgestimmt sind, d. h. einander entsprechende männliche oder weibliche Kontaktelemente tragen. Die Kontaktleiste 2 dient zum Verbinden des Prüfadapters mit dem betreffenden elektronischen Gerät anstelle der zu überprüfenden Schaltungsplatine 4, welche stattdessen mit der Kontaktleiste 3 des Prüfadapters verbunden wird. Zu sicheren Aufnahme und Halterung ist die Kontaktleiste 3 zur Aufnahme des Prüflings zusätzlich mit Führungen 5 und 6 aus Kunststoff versehen.

Die Kontaktleisten 2 und 3 sind auf der Bauelementeseite des platinenförmigen Trägers angeordnet, wobei die Leiterbahnen sowohl auf der Bauelemente als auch auf der Lötseite gegenüberliegend angeordnet sind. Der (strichpunktiert umrandete) Bereich 7 befindet sich bei in das Gerät eingestecktem Prüfadapter außerhalb der Zone, in der weitere Schaltungsplatinen benachbart sind. Er überragt diese benachbarten Schaltungsplatinen längenmäßig, so daß er für Prüfzwecke unbehindert zugänglich ist. In dem Bereich 7 sind Prüfbuchsen oder weitere Kontaktierungselemente vorgesehen, welche wie Bauelemente auf der Platine eingelötet sind und jeweils Verbindungen zu den Leiterbahnen haben. Auf diese Weise können an alle Leitungsverbindungen zu Prüfzwecken Meßklemmen oder -stecker angeschlossen werden. Auf der dem für Prüfbuchsen vorgesehenen Bereich gegenüberliegenden Seite (auf der Leiterseite) befindet sich ein Gehäuse 8 mit einem Display 9 für die Anzeige von Spannungszuständen auf den einzelnen Leiterbahnen.

Die zur Verarbeitung der Signale zwecks Ansteuerung der Leuchtdioden des Displays vorgesehenen elektrischen Baugruppen befinden sich innerhalb des Gehäuses 8, welches - da es von benachbarten Platinen im Gerät nicht behindert ist - eine beliebige Bauhöhe aufweisen darf. Das Display 9 ist während der Prüf- und Reparaturarbeiten auf der Schaltungsplatine 4 ungehindert einsehbar und wird auch nicht durch auf der Platine 4 befindliche elektronische Bauelemente behindert. Das Gehäuse 8 mit dem Display 9 ist mittels einer Steckverbindung, welche den Kontakt zu den einzelnen Leiterbahnen der Platine 1 herstellt, frei austausch- und gegebenenfalls entfernbar. Das Gehäuse 8 wird dabei mittels zweier Schrauben 11 zusätzlich fixiert.

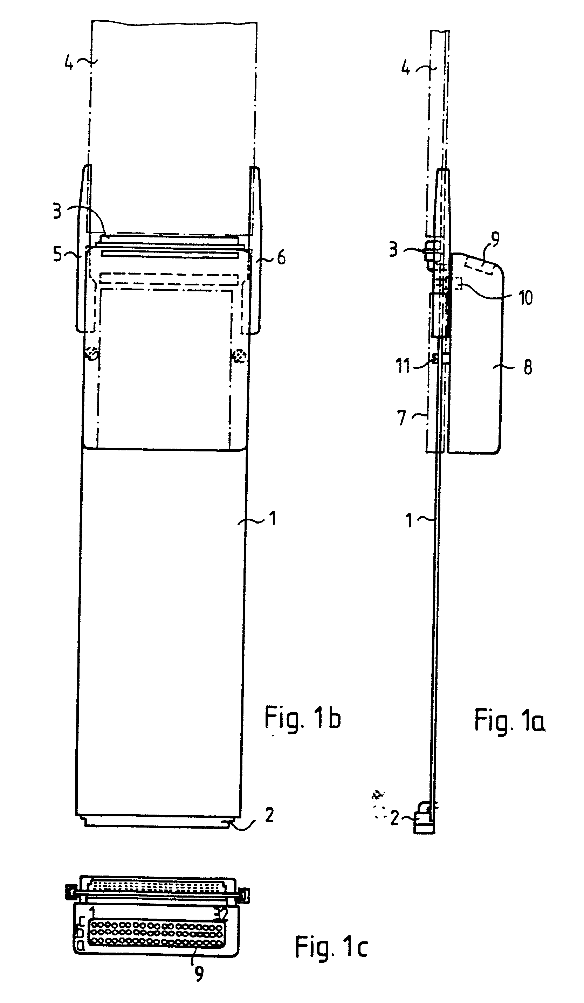

Die Anordnung der Leuchtdioden im Display 9 in Form einer Matrix ist in Figur 1c sichtbar. Das Gehäuse 8 mit dem Display 9 bildet eine kompakte Einheit, welche die Baulänge der Platine 1 des Prüfadapters nicht zusätzlich vergrößert und auch die Prüf- und Reparaturarbeiten in keine Weise behindert. Da zusätzliche Meßmittel jederzeit angeschlossen werden können, bildet die Anzeige 9 eine wesentliche Hilfe durch die Darstellung von Spannungszuständen, welche während der Prüf- und Reparaturarbeiten permanent von Interesse sind.

Bei dem in den Figuren 2a bis 2c dargestellten Ausführungsbeispiel befindet sich ein Gehäuse 8' mit einem Display 9' auf der Bauelementeseite des Prüfadapters, wobei das Gehäuse sich in einem Bereich erstreckt, welcher bei einer entsprechend in das Gerät eingefügten normalen Funktionsplatine von deren Bauelementen eingenommen wird. Die Bauhöhe des Gehäuses 8' überragt bevorzugt nicht die Höhe der Kontaktleiste 2, so daß der notwendige Raum für das Gehäuse 8' stets vorhanden ist.

Ein Display 9' befindet sich an derjenigen Stirnseite des Gehäuses 8', welche von der mit dem Grundgerät zu verbindenden Kontaktleiste 2 entfernt angeordnet ist. Da das Display 9' sich somit in einem Bereich befindet, der die benachbarten Schaltungsplatinen überragt, ist hier die Baugröße in der Höhe unbeschränkt, wobei die Anzeige die zur deutlich ablesbaren Darstellung notwendigen Ausmaße annehmen kann. Bei dieser Anordnung befindet sich das Display auf derselben Seite wie die Steckbuchsen bzw. Kontaktbereiche 7, so daß es bei den mittels weiterer Meßeinrichtungen durchzuführenden Prüfarbeiten jederzeit im Blickfeld gelegen ist. Es ist im übrigen soweit von der zu prüfenden Schaltungsplatine 4 entfernt, daß die Draufsicht auf das Display durch auf dieser Platine 4 vorhandene elektrische Bauelemente ebenfalls nicht behindert wird. Das Gehäuse 8' ist mittels einer Steckleiste 10' mit der Platine - entsprechend dem zuvor dargestellten Ausführungsbeispiel - lösbar verbunden, wobei die zusätzliche Fixierung mittels zweier Schraubenpaare 11' und 11" vorgenommen wird. Diese Ausführung hat zudem den Vorteil, daß die Steckleiste 10' auf der Bauelementeseite vorgesehen ist, so daß diese gemeinsam mit den anderen auf der Platine befindlichen Bauelementen gemeinsam in einem Lötbad befestigt werden kann.

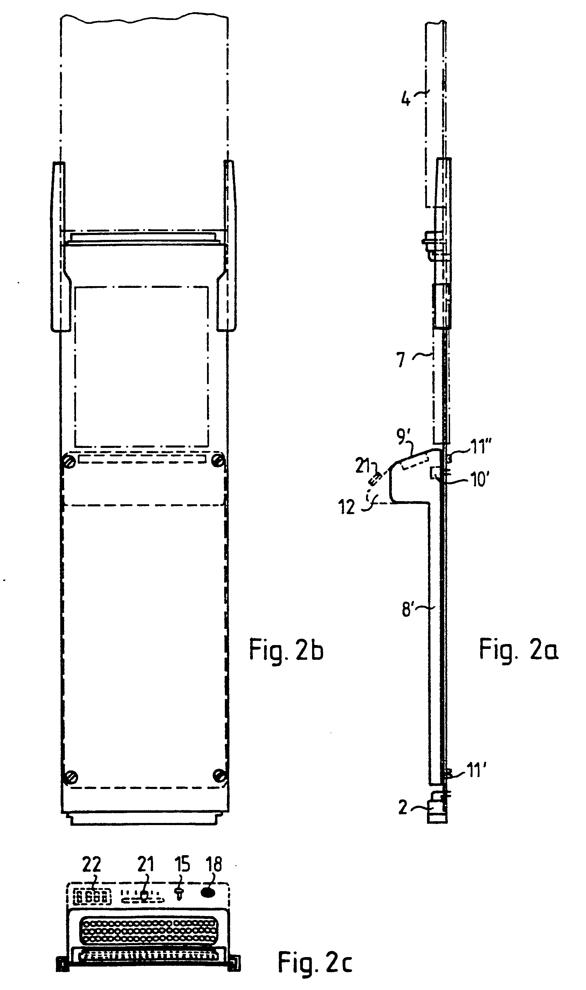

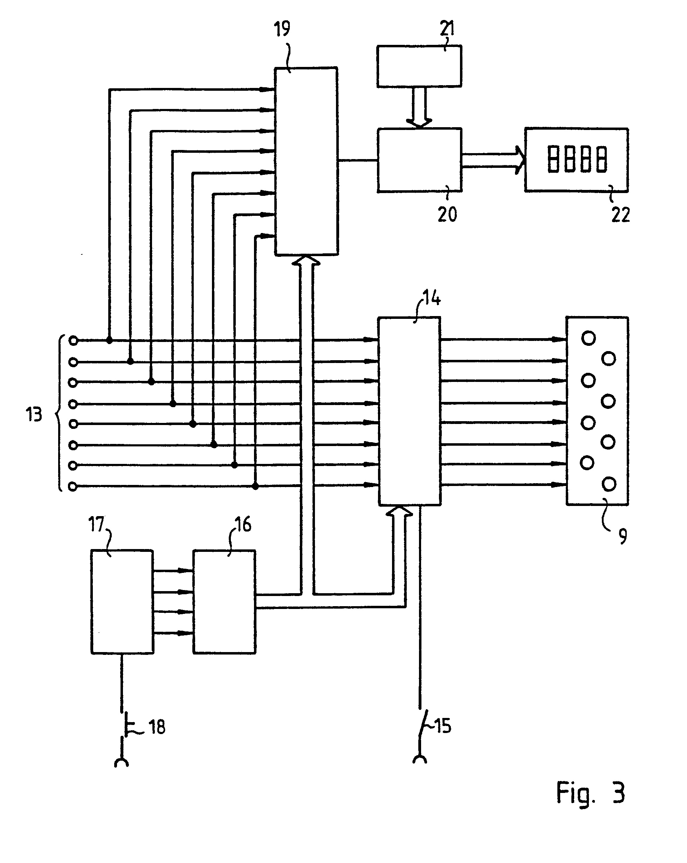

In Figur 2 ist gestrichelt eine Zusatzeinrichtung in das Display-Gehäuse einbezogen, welche die Anzeige von elektrischen Kennwerten einzelner der zu überprüfender Signalleitungen ermöglicht. Damit ist das Gehäuse durch einen Aufsatz 12 pultförmig ergänzt, wie in Figur 2a erkennbar ist. Die pultförmige Erhöhung kann dabei - entsprechend den Anforderungen - mehr oder weniger flach gestaltet sein, so daß die Zunahme des Bauhöhe nur gering ist. Die Prinzipschaltung des in Figur 2a dargestellten Zusatzes ist in Figur 3 wiedergegeben. Die Leiterbahnen 13 sind an einen digitalen Umschalter 14 einzeln herangeführt, der im Normalbetrieb die an den einzelnen Leiterbahnen anliegenden, den in Betrieb auftretenden Spannungen entsprechenden Signale zu dem Leuchtdioden-Display 9 hinführt. In diesem Fall sind die dargestellten Verbindungen also durchgeschaltet, wobei entweder im Schalter 14 oder in der Display-Anordnung 9 eine Digitalisierung des Signals in dem Sinne erfolgt, daß bei einer Signalspannung oberhalb eines vorgegebenen Schwellenwerts die jeweils zugeordnete Diode aufleuchtet.

Mittels eines Schalters 15 läßt sich die Diodenanzeige wahlweise so ansteuern, daß mittels eines Adreßdecoders 16 lediglich eine der Positionen des Diodendisplays aufleuchtet - und zwar nur diejenige Position, welche dem aktuellen Stand eines Zählers 17 entspricht. Der höchste erreichbare Zählerstand des Zählers 17 entspricht der Anzahl der Diodenelemente des Displays 9, wobei in der vereinfachten Darstellung gemäß Figur 3 insgesamt acht Anzeigen vorgesehen sind. Nach dem Erreichen des höchsten Zählerstandes geht der Zähler beim nächsten mittels eines Tasters 18 über seinen Takteingang eingegebenen Impulses wieder in die Position "0" zurück.

Parallel mit dem adressierbaren Digitalschalter wird vom Adreßdecoder 16 ein adressierbarer Analogschalter 19 so betätigt, daß dasjenige elektrische Signal einer der Leiterbahnen 13 zu einer Signalauswerteschaltung 20 weitergeleitet wird, dessen zugeordnete Leuchtdiode im Display 9 aktiviert ist. In der Auswerteschaltung 20 wird das auf der entsprechenden Leiterbahn 13 ankommende Signal, welches mittels des Schalters 19 zur Auswerteschaltung 20 durchgeschaltet ist, elektrisch aufbereitet und ein Ansteuersignal für eine Digitalanzeige 22 erzeugt. Bei der Signalaufbereitung kann es sich um die Auswertung eines Spannungswertes - entsprechend einem digitalen Voltmeter - um eine Frequenzmessung (mit Digitalanzeige des Zahlenwertes) oder auch um eine Analyse eines digitalen Signals nach logischen Kriterien handeln, wobei das Vorhandensein vorgegebener Signalzustände dem Benutzer über das Display 22 mitgeteilt wird.

Die Aktivierung und Steuerung des Verarbeitungsteils 20 erfolgt über einen Funktions- und Meßbereichsschalter 21. Das Weiterschalten des Zählers 17 kann dabei auf unterschiedliche Art und Weise vorgenommen werden: Günstig sind dabei entweder Ausführungen, welche den Zähler bei Betätigung eines Tastenelementes (wie dargestellt) durch impulsweise Betätigung weitersetzen oder aber bei Vorhandensein eines selbständigen Taktgenerators wird der Zähler fortgeschaltet, solange ein dem Ausgang dieses Taktgenerators mit dem Takteingang des Zählers 17 verbindendes Tastenelement aktiviert ist. Des weiteren sind auch Ausführungen vorteilhaft anwendbar, welche eine direkte Adressierung einer Leitung, beispielsweise mittels eines Tastenfeldes oder durch Berührung der Anzeigefläche eines Sensorflächen enthaltenden Anzeigefeldes, ermöglichen.

Die Erfindung beschränkt sich in ihrer Ausführung nicht auf das vorstehend angegebene Beispiel. Vielmehr sind eine Vielzahl von Varianten denkbar, welche von der dargestellten Lösung auch bei grundsätzlich anders gearteten Ausführungen Gebrauch machen. Insbesondere beschränkt sich die Ausführung nicht auf die Realisierung mit diskreten logischen Baugruppen, sondern läßt sich vorteilhaft auch mit programmierter Logik - insbesondere unter Verwendung eines Mikroprozessors - realisieren.

**Patentansprüche**

1. Prüfadapter für eine elektronische Schaltungsplatine, zur zeitweiligen Halterung der Schaltungsplatine außerhalb des Gerätes, das im üblichen Betriebszustand zur Aufnahme der Schaltungsplatine dient, der aufweist:
   - einen platinenförmigen Bauelementeträger (1),
   - zwei einander gegenüberliegende, aneinander angepaßte Kontaktleisten (2) an den Stirnseiten des Bauelementeträgers (1), die als eine Feder- und eine Messerleiste ausgebildet sind, wobei
   - einander zugeordnete Kontakte der Feder- und der Messerleiste jeweils mit einer entlang des Bauelementeträgers (1) verlaufenden Bahn aus elektrisch leitendem Werkstoff verbunden sind,
   - jede Bahn weiterhin mindestens einen von außerhalb des Gerätes zugänglichen Kontaktbereich (7), insbesondere eine Prüfbuchse, aufweist und diese Prüfbuchse die zur Aufnahme der zu prüfenden Platine dienenden Kontaktleiste (2) räumlich benachbart angeordnet ist,
   dadurch gekennzeichnet
   daß eine Display-Anordnung (9, 9') zur optischen Anzeige elektrischer Kennwerte der auf den Leiterbahnen vorhandenen Signale in räumlicher Nähe zu dem Kontaktbereich (7) angeordnet ist, wobei
   - mindestens ein Gehäuse (8) für elektronische Bauelemente auf dem platinenförmigen Bauelementeträger (1) auf derselben Seite neben dem Kontaktbereich (7) und/oder dem Kontaktbereich (7) direkt gegenüberliegend auf der anderen Seite des Bauelementeträgers (1) vorgesehen ist und
   - das Gehäuse (8) auf dem Bauelementeträger (1) wahlweise derart angeordnet ist, daß es entweder neben dem Kontaktbereich angeordnet ist und gleichzeitig seine Bauhöhe nicht über der der Kontaktleisten liegt, oder daß es außerhalb der Zone liegt welche sich im Prüfzustand zwischen den benachbarten Schaltungsplatinen befindet.

2. Prüfadapter nach Anspruch 1, dadurch gekennzeichnet, daß die Display-Anordnung (9, 9') in das Gehäuse (8, 8') integriert ist.

3. Prüfadapter nach einem der vorangehenden Ansprüche, dadurch gekennzeichnet, daß die Display-Anordnung (9, 9') in Richtung auf die Kontaktleiste (3) zur Aufnahme des Prüflings weisend angeordnet ist.

4. Prüfadapter nach einem der vorangehenden Ansprüche, dadurch gekennzeichnet, daß das Gehäuse (8') auf der Bestückungsseite des Bauelementeträgers (1) der Kontaktleiste (2) zum Verbinden mit dem Gerät benachbart angeordnet ist.

5. Prüfadapter nach einem der vorangehenden Ansprüche, dadurch gekennzeichnet, daß das Gehäuse (8) benachbart dem Kontaktbereich (7) auf der Lötseite des Bauelementeträgers (1) angeordnet ist.

6. Prüfadapter nach einem der vorangehenden Ansprüche, dadurch gekennzeichnet, daß die Bauhöhe des Gehäuses (8') auf der Bauelementeseite des Bauelementeträgers (1) im wesentlichen nicht die Bauhöhe der Kontaktleiste (2) zum Verbinden mit dem Gerät überragt.

7. Prüfadapter nach einem der vorangehenden Ansprüche, dadurch gekennzeichnet, daß das Gehäuse (8, 8') samt Display-Anordnung (9, 9') über eine Steckverbindung (10, 10') mit dem Bauelementeträger (1) verbunden ist.

8. Prüfadapter nach einem der vorangehenden Ansprüche, dadurch gekennzeichnet, daß verbunden mit der Display-Anordnung (9) eine zusätzliche digitale oder analoge Anzeigeeinrichtung (22) mit zugehörigem Signalverarbeitungsteil (20) für mindestens eine elektrische Eigenschaft eines auf einer der Leiterbahnen vorhandenen Signals vorgesehen ist.

9. Prüfadapter nach Anspruch 8, dadurch gekennzeichnet, daß eine Schaltvorrichtung (19) vorgesehen ist, welche die Anzeigeeinrichtung (22) jeweils einer der Leiterbahnen (13) alternativ zuordnet.

10. Prüfadapter nach Anspruch 9, dadurch gekennzeichnet, daß die Schaltvorrichtung (19) mittels einer Auswahlvorrichtung (16) steuerbar ist, welche über entsprechende Schaltmittel (14) gleichzeitig dasjenige Anzeigeelement der Display-Anordnung (9) adressiert, das derjenigen Leiterbahn (13) zugeordnet ist, für die eine elektrische Eigenschaft eines darauf vorhandenen Signals angezeigt wird, wobei die Auswahlvorrichtung (16) insbesondere ein Schaltelement (18) aufweist, durch dessen impulsweise oder zeitabschnittweise Betätigung jeweils ein Zähler (17) weitergesetzt wird, der vor die Auswahlvorrichtung ansteuert und somit entsprechend dem Zählerstand nacheinander sowohl das entsprechende Anzeigeelement als auch die Anzeigeeinrichtung den einzelnen Leiterbahnen (13) zuordnet.

## Claims

1. A test adapter for an electronic printed circuit board, to bold the printed circuit board temporarily outside the equipment which serves to receive the printed circuit board in the usual operating state, which adapter comprises:
- a component carrier (1) in the form of a board,
- two contact stripe (2) which are adapted to one another and situated opposite one another at the ends of the component carrier (1) and which are constructed in the form of female multipoint connector and of a male multipoint connector, while
- associated contacts of the male and female multipoint connectors are connected, in each case, by a path of electrically conducting material extending along the component carrier (1),
- each path further comprises at least one contact region (7), particularly a test terminal, which is accessible from outside the equipment, and this test terminal is arranged spatially adjacent to the contact strip (2) serving to receive the circuit board to be tested,
characterised in that,
- a display arrangement (9, 9') is disposed in the spatial vicinity of the contact region (7) for the optical display of electrical characteristic values of the signals present on the conducting paths, and
- at least one housing (8) for electronic components is provided on the component carrier (1) in the form of a circuit board, beside the contact region (7) at the same side and/or directly opposite the contact region (7) at the other side of the component carrier (1), and
- the housing (8) is selectively disposed on the component carrier (1) in such a manner that it is either arranged beside the contact region and at the same time its structural height is not above that of the contact strips, or that it is situated outside the zone which is between the neighbouring printed circuit boards in the test state.

2. A test adapter according to Claim 1, characterised in that the display arrangement (9, 9') is integrated in the housing (8, 8').

3. A test adapter according to either one of the preceding Claims, characterised in that the display arrangement (9, 9') is arranged facing towards the contact strip (3) to receive the device under test.

4. A test adapter according to any one of the preceding Claims, characterised in that the housing (8') is disposed on the component side of the component carrier (1), adjacent to the contact strip (2) for connection to the equipment.

5. A test adapter according to any one of the preceding Claims, characterised in that the housing (8) is disposed on the solder side of the component carrier (1), adjacent to the contact region (7).

6. A test adapter according to any one of the preceding Claims, characterised in that the structural height of the housing (8') on the component side of the component carrier (1) does not project substantially above the structural height of the contact strip (2) for connection to the equipment.

7. A test adapter according to any one of the preceding Claims, characterised in that the housing (8, 8') together with the display arrangement (9, 9') is connected to the component carrier (1) by a plug connection (10, 10').

8. A test adapter according to any one of the preceding Claims, characterised in that an additional digital or analogue display device (22) with associated signal processing unit (20) for at least one electrical characteristic of a signal present on one of the conducting paths is provided connected to the display arrangement (9).

9. A test adapter according to Claim 8, characterised in that a switching device (19) is provided which allocates the display device (22) to one of the conducting paths (13) at a time.

10. A test adapter according to Claim 9, characterised in that the switching device (19) can be controlled by means of a selection device (16) which, through appropriate switching means (14), simultaneously addresses that display element of the display arrangement (9) which is associated with that conducting path (13) for which an electrical characteristic of a signal present thereon is being displayed, and the selection device (16) comprises, in particular, a circuit element (18) through the pulsewise or periodic actuation of which, a counter (17) is stepped on each time, which counter actuates the selection device and so allocates both the corresponding display element and the display device to the individual conducting paths (13) in succession according to the counter contents.

**Revendications**

1. Adaptateur de test pour une carte à circuits imprimés ou un dispositif électronique semblable, destiné à supporter la carte imprimée temporairement à l'extérieur de l'appareil recevant la carte à l'état de fonctionnement normal, adaptateur qui comprend:
- un support (1) en forme de plaque, portant des composants,
- deux réglettes de contacts (2) mutuellement adaptées et disposées l'une à l'opposé de l'autre sur les extrémités avant et arrière du support (1), l'une réalisée comme une réglette de contacts à ressort et l'autre comme une réglette de contacts à couteau, et sur lequel
- les contacts mutuellement coordonnés de la réglette de contacts à ressort et de la réglette de contacts à couteau sont reliés entre eux par une piste en matériau conducteur électrique s'étendant le long du support (1),
- chaque piste présentant au moins une région de contact (7) accessible de l'extérieur de l'appareil et constituée en particulier par une prise de test, disposée à proximité de la réglette de contacts (2) servant à la réception de la carte à tester,
caractérisé en ce
- qu'un afficheur (9, 9') pour l'affichage visuel de caractéristiques électriques des signaux appliqués aux pistes conductives, est disposé à proximité de la région de contact (7),
- au moins un boîtier (8) pour des composants électroniques étant prévus sur le support (1) en forme de plaque, sur la même face et à côté de la région de contact (7) et/ou directement à l'opposé de la région de contact (7) sur l'autre face du support (1), et
- le boîtier (8) étant disposé sur le support (1), au choix, soit de manière qu'il se trouve à côté de la région de contact et que, en même temps, sa hauteur d'encombrement ne dépasse pas celle des réglettes de contacts, soit de manière qu'il se trouve en dehors de la zone située à l'état de test entre les cartes imprimées voisines.

2. Adaptateur selon la revendication 1, caractérisé en ce que l'afficheur (9, 9') est intégré dans le boîtier (8, 8').

3. Adaptateur selon l'une des revendications précédentes, caractérisé en ce que l'afficheur (9, 9') est dirigé vers la réglette de contacts (3) destinée à recevoir la carte à tester.

4. Adaptateur selon l'une des revendications précédentes, caractérisé en ce que le boîtier (8') est disposé côté composants du support (1), à proximité de la réglette de contacts (2) pour le raccordement à l'appareil.

5. Adaptateur selon l'une des revendications précédentes, caractérisé en ce que le boîtier (8) est disposé à proximité de la région de contact (7) du côté brasage du support (1).

6. Adaptateur selon l'une des revendications précédentes, caractérisé en ce que la hauteur d'encombrement du boîtier (8') sur le côté composants du support (1) ne dépasse pas, ou ne dépasse pratiquement pas la hauteur d'encombrement de la réglette de contacts (2) pour le raccordement à l'appareil.

7. Adaptateur selon l'une des revendications précédentes, caractérisé en ce que le boîtier (8, 8') est relié au support (1), conjointement avec l'afficheur (9, 9'), par un connecteur à enfichage (10, 10').

8. Adaptateur selon l'une des revendications précédentes, caractérisé en ce qu'il comprend un afficheur supplémentaire (22), numérique ou analogique, qui est relie à l'afficheur (9) précité et auquel est associée une partie de traitement de signal (20) pour au moins une propriété électrique d'un signal appliqué à l'une des pistes conductives.

9. Adaptateur selon la revendication 8, caractérisé en ce qu'il comprend un dispositif de commutation (19) pour coordonner l'afficheur supplémentaire (22) alternativement à l'une des pistes conductives (13).

10. Adaptateur selon la revendication 9, caractérisé en ce que le dispositif de commutation (19) peut être commandé au moyen d'un dispositif de sélection (16) qui, par des moyens de commutation (14) adéquats, adresse simultanément l'élément d'affichage de l'afficheur (9) coordonné à la piste conductive (13) pour laquelle est affiché une propriété électrique d'un signal appliqué à cette piste, le dispositif de sélection (16) présentant notamment un élément de commutation (18) dont l'actionnement par impulsions ou par intervalles de temps provoque chaque fois l'avancement d'un compteur (17) qui pilote le dispositif de sélection et coordonne ainsi, successivement, en fonction de la position du compteur, à la fois l'élément d'affichage concerné et l'afficheur aux différentes pistes conductives (13).

Fig. 1b

Fig. 1a

Fig. 1c

Fig. 2b

Fig. 2a

Fig. 2c

Fig. 3